# DEMANDE DE BREVET EUROPEEN

(11) **EP 1 272 015 A1**
(43) Date de publication de la demande: **02.01.2003**
(21) Numéro de dépôt: 02291487.3
(22) Date de dépôt: 14.06.2002
(51) Int. Cl.: H05H 1/46, H01J 37/32

(54) **Dispositif pour la production d'ions de charges positives variables et à résonance cyclotronique**

(30) Priorité: 22.06.2001 FR 0108244
(71) Demandeur: Pantechnik, 14000 Caen (FR)
(72) Inventeur: Sortais, Pascal, 38240 Meylan (FR); Bieth, Claude, 14310 Monts en Bessin (FR); Kantas, Said, 14000 Caen (FR)
(74) Mandataire: Le Bras, Hervé

(57) **Abrégé**

L'invention concerne un dispositif de confinement d'un plasma engendré par résonance cyclotronique pour la production d'ions de charges positives variables du type comprenant notamment
des premiers moyens magnétiques (1) pour générer un champ dans une enceinte (E) sous vide destinée à renfermer un plasma,
des seconds moyens magnétiques (2) pour générer un champ radial en vue de confiner ledit plasma à l'intérieur de l'enceinte (E), et
des moyens (5) pour transférer aux électrons du plasma une énergie électromagnétique haute fréquence correspondant à leur résonance en vue de l'ionisation dudit plasma
caractérisé en ce que lesdits premiers et seconds moyens magnétiques (1, 2) sont constitués d'éléments annulaires coaxiaux et juxtaposés dont les diamètres intérieurs sont identiques et qui forment un tube magnétique délimitant latéralement ladite enceinte (E).

## Description

La présente invention concerne un dispositif de confinement d'un plasma pour la production d'ions de charges positives variables.

Ces dispositifs appelés souvent sources ECR utilisent les propriétés de résonance des électrons en présence d'un champ magnétique B qui sont régies par la relation B = (2 πmF)/e où m et e sont respectivement la masse et la charge de l'électron et F la fréquence de l'onde électromagnétique.

De tels dispositifs comprennent généralement des premiers moyens magnétiques pour générer un champ axial dans une enceinte sous vide destinée à renfermer un plasma,
des seconds moyens magnétiques pour générer un champ radial en vue de confiner ledit plasma à l'intérieur de l'enceinte,
des moyens pour transférer aux électrons du plasma une énergie électromagnétique haute fréquence correspondant à leur résonance cyclotronique en vue de l'ionisation dudit plasma et, le cas échéant,
des moyens pour extraire les ions ainsi formés de ladite enceinte.

Les ions sont extraits sous forme d'un faisceau susceptible d'être utilisé pour la réalisation de composants électroniques par implantation ionique ou pour la gravure ionique de certains matériaux ou bien encore pour le nettoyage de surfaces ou toute autre application nécessitant des ions lourds à faible ou haute énergie.

Cependant, ces dispositifs sont très volumineux et donc encombrants du fait que la configuration géométrique extérieure desdits premiers moyens magnétiques générateurs de champ et des moyens de transfert de l'énergie électromagnétique est aléatoire et ne répond en tous cas à aucune optimisation ou adaptation en fonction d'un environnement mécanique spécifique et en vue d'une intégration dans les installations d'implantation ou de gravure ionique existantes.

La présente invention a pour but de résoudre ces problèmes techniques en simplifiant la structure de ces dispositifs et en réduisant notamment l'encombrement des moyens générateurs de champ tout en optimisant à la fois leur effet magnétique et le transfert de l'énergie électromagnétique.

Ce but est atteint au moyen d'un dispositif du type précédent, caractérisé en ce que lesdits premiers et seconds moyens magnétiques sont constitués d'éléments annulaires coaxiaux et juxtaposés dont les diamètres intérieurs sont identiques et qui forment un tube magnétique délimitant latéralement ladite enceinte.

Selon une caractéristique avantageuse, lesdits moyens de transfert de l'énergie électromagnétique comprennent une antenne émettrice sous forme d'un profilé dont la géométrie est fonction de la fréquence et qui est relié par couplage électromagnétique à un générateur haute fréquence.

Selon une variante de réalisation, ledit profilé fait saillie axialement à l'intérieur dudit tube magnétique

Selon une autre caractéristique, ledit profilé est creux et assure en outre, l'injection de gaz à l'intérieur de l'enceinte.

Selon une variante de réalisation, ledit profilé est relié latéralement au générateur haute fréquence.

De préférence, ledit profilé est relié au générateur par une fenêtre étanche au vide, pourvue extérieurement d'un guide d'onde.

Selon une variante spécifique, ledit profilé est coaxial à une chemise interne en matériau conducteur disposée à l'intérieur du tube magnétique.

Selon une autre variante, lesdits premiers moyens magnétiques sont disposés de part et d'autre des seconds moyens magnétiques.

Selon encore une autre caractéristique, lesdits éléments annulaires des premiers moyens magnétiques comprennent au moins un anneau à aimantation radiale.

Selon d'autres caractéristiques, lesdits éléments annulaires des seconds moyens magnétiques comprennent au moins un anneau à aimantation multipolaire.

De préférence, lesdits moyens de transfert de l'énergie électromagnétique sont pourvus d'un organe d'adaptation de leur impédance avec celle du plasma.

Selon un mode de réalisation spécifique, le dispositif comprend, en outre, des moyens pour extraire les ions formés de ladite enceinte (E).

Le dispositif de l'invention permet, grâce à sa structure modulaire, de produire différents profils de champs magnétiques, en fonction des applications recherchées.

Le rendement des moyens de transfert de l'énergie électromagnétique est en outre optimisé ce qui facilite les réglages d'impédance.

Le dispositif de l'invention est particulièrement compact et d'encombrement réduit et offre une grande souplesse d'utilisation pour des applications industrielles très diversifiées.

L'invention sera mieux comprise à la lecture de la description qui va suivre en référence aux dessins annexés sur lesquels :
la figure 1 représente une vue schématique en coupe d'un dispositif selon l'art antérieur ;
la figure 2 représente une vue schématique en coupe d'un mode de réalisation du dispositif de l'invention ;
la figure 3 représente une vue partielle d'une variante de réalisation du dispositif de la figure 2 ;
les figures 4A et 4B représentent deux autres modes de réalisation du dispositif de l'invention ;
la figure 5 représente les profils des champs magnétiques axiaux produits par les premiers moyens magnétiques du dispositif de l'invention.

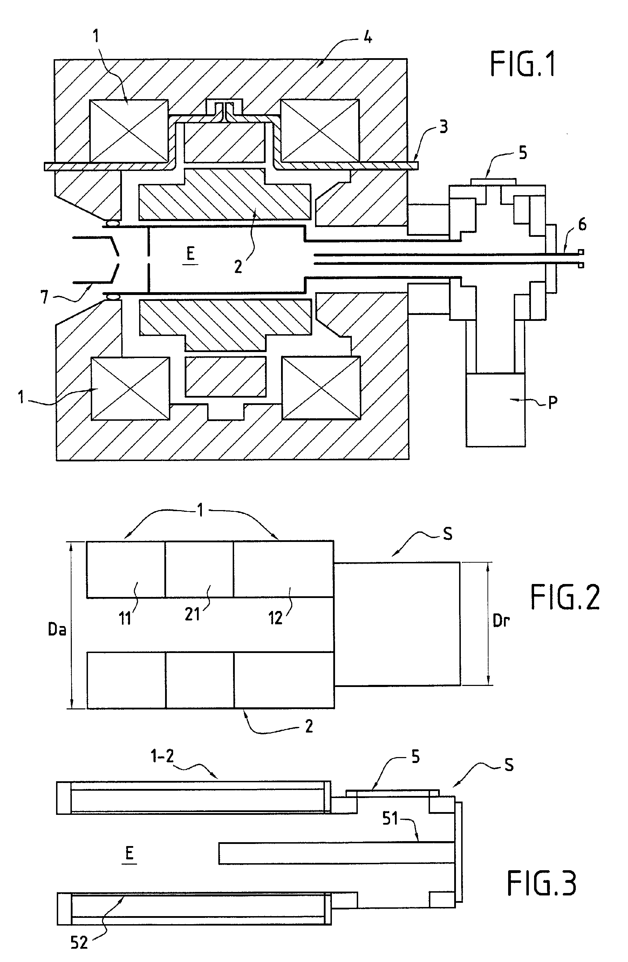

Le dispositif représenté sur la figure 1 est destiné au confinement d'un plasma pour la production d'ions de charges positives variables.

Ce dispositif, dénommé souvent source ECR, comprend des premiers moyens magnétiques 1 (aimants permanents et/ou bobines) pour générer un champ axial dans une enceinte E maintenue sous vide grâce à un système de pompage P.

Ces premiers moyens magnétiques entourent l'enceinte E.

Un plasma est produit à l'intérieur de l'enceinte E par ionisation d'un gaz introduit dans ladite enceinte sous forme atomique au moyen d'une buse d'injection 6.

Ce plasma est confiné à l'intérieur de l'enceinte E dans une zone déterminée par des seconds moyens magnétiques 2 générant un champ radial.

Les seconds moyens magnétiques 2 sont séparés des premiers moyens magnétiques 1 par un élément isolant 3. Les premiers et seconds moyens magnétiques sont enfermés dans une culasse extérieure 4 en acier.

Dans cette zone de confinement délimitée par un ellipsoïde de révolution, le plasma est dense et à haute température.

Au voisinage de cette zone se trouvent des poches de capture et de diffusion lente des ions.

A la périphérie de la zone ellipsoïdale de plasma dense et à l'interface avec lesdites poches se trouve une surface dite résonante où les électrons sont dans un état de résonance cyclotronique. Cet état est le résultat du transfert aux électrons d'une énergie électromagnétique haute fréquence produite par un générateur UHF (non représenté) et couplé au plasma par une ligne conductrice extérieure telle qu'un guide d'onde (non représentée) via une fenêtre 5.

Les ions formés dans le plasma quittent l'enceinte E à l'extrémité opposée à l'injection et sont accélérés par les moyens d'extraction 7. Pour la production d'un faisceau étroit d'ions, les moyens d'extraction 7 comporteront un orifice unique tandis que, pour obtenir un faisceau large, les moyens 7 seront dotés d'une grille à plusieurs orifices.

Dans le dispositif de l'invention, tel qu'il est représenté schématiquement sur la figure 2, les premiers et seconds moyens magnétiques 1, 2 sont constitués d'éléments annulaires coaxiaux et juxtaposés dont les diamètres intérieurs sont sensiblement identiques, en vue de former un tube magnétique compact délimitant latéralement l'enceinte E.

Les premiers moyens magnétiques 1 comprennent au moins un anneau 11, 12 à aimantation radiale et sont disposés de part et d'autre des seconds moyens magnétiques 2, qui comprennent au moins un anneau 21 à aimantation multipolaire.

Le dispositif est équipé à l'une des extrémités du tube (ici à l'extrémité droite) d'un système S d'amenée, de couplage et d'adaptation d'impédance de l'onde électromagnétique HF. Les diamètres avant Da et arrière Dr sont adaptés aux dimensions des installations d'implantation ionique ou de gravure utilisant les ions accélérés par le dispositif.

Une variante (non représentée) consiste à prévoir des organes mécaniques permettant de déplacer ou de rendre amovibles les éléments annulaires des premiers et seconds moyens magnétiques 1, 2 de façon à faire évoluer le profil du champ magnétique et de modifier ainsi les caractéristiques mécaniques du faisceau d'ions extraits.

La figure 3 illustre le principe du système de couplage S dans le cas de l'utilisation d'une fenêtre (UHF) 5 disposée latéralement et assurant le passage de l'onde électromagnétique tout en effectuant une séparation étanche entre l'atmosphère extérieure et l'enceinte E formant chambre de plasma.

D'une façon générale, le couplage latéral de l'onde électromagnétique s'effectue en utilisant une antenne émettrice sous forme d'un profilé 51 dont la géométrie est choisie en fonction de la fréquence de fonctionnement de la source. Ce profilé est relié par couplage électromégnatique au générateur haute fréquence et fait saillie axialement à l'intérieur du tube magnétique délimitant l'enceinte E. De préférence, le profilé 51 est coaxial à une antenne réceptrice 52 sous forme d'une chemise interne en matériau conducteur garnissant l'intérieur du tube magnétique 1, 2.
. En outre, le profilé est relié latéralement au générateur haute fréquence.

Pour les fréquences élevées (supérieures à 10 GHz) la liaison est réalisée via la fenêtre 5 qui est étanche au vide, mais qui laisse passer sans perte les rayonnements électromagnétiques. La fenêtre 5 est connectée extérieurement à un guide d'onde adapté à la fréquence de fonctionnement de la source.

Pour les fréquences plus basses (autour de 2 GHz) la fenêtre 5 est pourvue d'une traversée étanche connectée à un câble coaxial. Ce mode de couplage utilise donc une antenne coaxiale étanche dont les dimensions sont faibles relativement à celles du tube magnétique ce qui est particulièrement avantageux lorsque les fréquences de résonance sont basses (2,45 GHz par exemple).

Le profilé axial 51 peut, en outre, être creux en vue d'assurer l'injection de gaz (sous forme atomique) à l'intérieur de l'enceinte ce qui laisse libre l'axe de la source et permet d'éviter les dépôts polluants sur la fenêtre UHF en céramique, réduisant ainsi les interventions de maintenance. Ce profilé creux permet aussi la production d'ions métalliques par effet "sputtering".

Dans le système S se trouve également un organe mécanique à position variable permettant de réaliser une adaptation parfaite entre l'impédance du plasma et l'impédance du guide d'onde ou du câble coaxial et l'impédance du générateur. Cet organe peut, dans certains cas être réglé une fois pour toutes en usine ou, au contraire, être associé à un système électronique permettant une adaptation d'impédance automatique. Cette adaptation est nécessaire pour optimiser le fonctionnement du générateur et la puissance électromagnétique disponible.

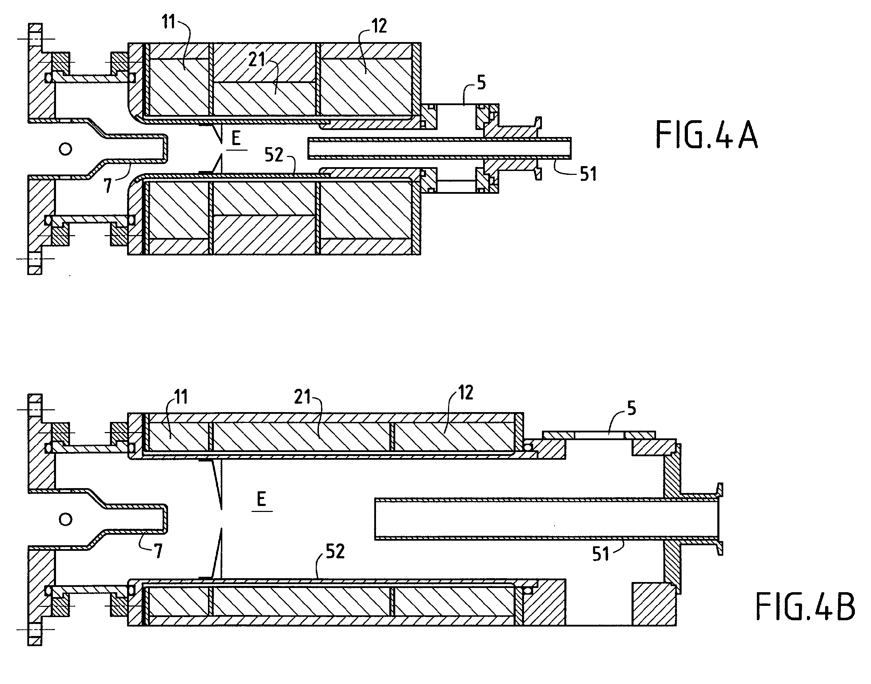

Les figures 4A et 4B représentent deux modes de réalisation du dispositif de l'invention sous forme de sources ECR à tube magnétique cylindrique de diamètres intérieur et extérieur uniformes.

La figure 4A est relative à une source travaillant à une fréquence de 10 GHz tandis que la figure 4B concerne une source travaillant à une fréquence de 2,45 GHz.

Les principales dimensions sont données à titre indicatif sur les figures et exprimées en millimètres.

Les flèches représentent les déplacements radiaux possibles pour les éléments annulaires 11, 12 des premiers moyens magnétiques 1.

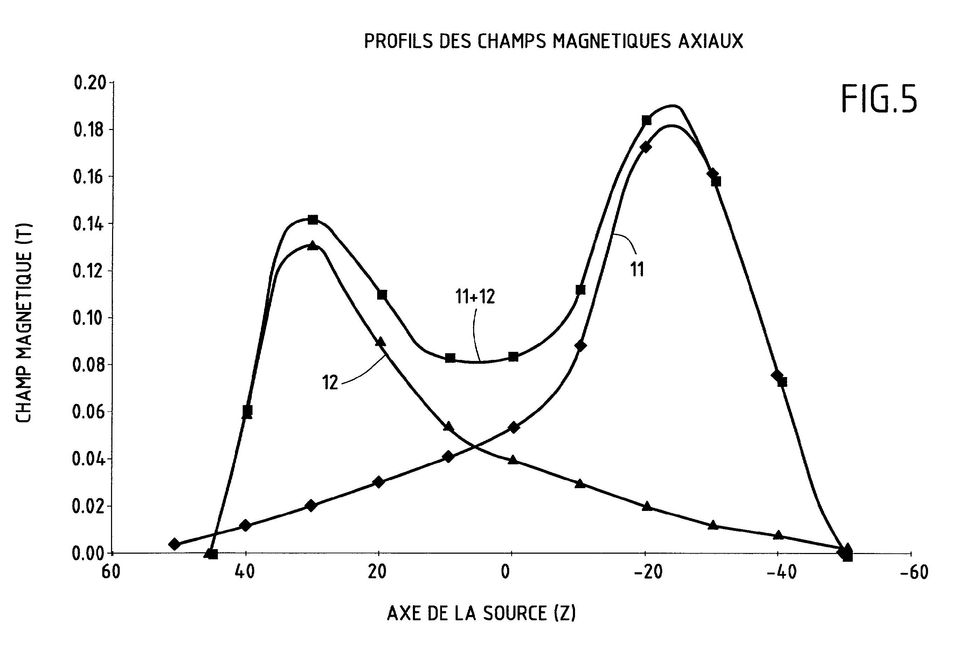

La figure 5 représente le profil du champ magnétique axial créé dans l'enceinte E respectivement, par chacun des anneaux magnétiques 11, 12 à aimantation radiale pris isolément ainsi que par la juxtaposition de ces éléments annulaires constituant les premiers moyens magnétiques 1. Le dispositif présente alors la configuration d'une source ECR dite "à miroir magnétique".

L'utilisation d'un seul anneau magnétique 11, 12 correspond à une source dite "à simple gradient". Le faisceau d'ions extraits dans une telle configuration peut alors être très large et très intense ce qui s'avère très utile pour le nettoyage de surfaces (décapages....). Par ailleurs, l'utilisation d'un seul anneau à aimantation radiale 11, 12 avec les seconds moyens magnétiques 2 sous la forme d'un anneau à aimantation multipolaire 21, correspond à une source multipolaire avec gradient.

L'intégration dans le dispositif entre les anneaux 11, 12 des seconds moyens magnétiques 2 sous forme d'un anneau 21 à aimantation multipolaire (comme représenté sur la figure 2) correspond à une source ECR dite à "minimum B". La qualification et le mode de fonctionnement de ces sources sont indépendants du volume de l'enceinte E. En outre, ces configurations peuvent être utilisées avec des niveaux différents de champ magnétique (et donc de haute fréquence) pour obtenir des ions avec des états de charge su périeurs à +3e⁻.

## Revendications

1. Dispositif de confinement d'un plasma engendré par résonance cyclotronique pour la production d'ions de charges positives variables du type comprenant notamment
des premiers moyens magnétiques (1) pour générer un champ dans une enceinte (E) sous vide destinée à renfermer un plasma,
des seconds moyens magnétiques (2) pour générer un champ radial en vue de confiner ledit plasma à l'intérieur de l'enceinte (E), et
des moyens (5) pour transférer aux électrons du plasma une énergie électromagnétique haute fréquence correspondant à leur résonance en vue de l'ionisation dudit plasma
**caractérisé en ce que** lesdits premiers et seconds moyens magnétiques (1, 2) sont constitués d'éléments annulaires coaxiaux et juxtaposés dont les diamètres intérieurs sont identiques et qui forment un tube magnétique délimitant latéralement ladite enceinte (E).

2. Dispositif selon la revendication 1, **caractérisé en ce que** lesdits moyens (7) de transfert de l'énergie électromagnétique comprennent une antenne émettrice sous forme d'un profilé (51) dont la géométrie est fonction de la fréquence et qui est relié par couplage électromagnétique à un générateur haute fréquence.

3. Dispositif selon la revendication 2, **caractérisé en ce que** ledit profilé (51) fait saillie axialement à l'intérieur dudit tube magnétique.

4. Dispositif selon la revendication 2 ou 3, **caractérisé en ce que** ledit profilé (51) est creux et assure en outre, l'injection de gaz à l'intérieur de l'enceinte (E) .

5. Dispositif selon l'une des revendications 2 à 4, **caractérisé en ce que** ledit profilé (51) est relié latéralement au générateur haute fréquence.

6. Dispositif selon la revendication 5, **caractérisé en ce que** ledit profilé (51) est relié au générateur par une fenêtre (5) étanche au vide, pourvue extérieurement d'un guide d'onde.

7. Dispositif selon l'une des revendications 2 à 6, **caractérisé en ce que** ledit profilé (51) est coaxial à une chemise interne (52) en matériau conducteur disposée à l'intérieur du tube magnétique.

8. Dispositif selon l'une des revendications précédentes, **caractérisé en ce que** lesdits premiers moyens magnétiques (1) sont disposés de part et d'autre des seconds moyens magnétiques (2).

9. Dispositif selon l'une des revendications précédentes, **caractérisé en ce que** lesdits éléments annulaires des premiers moyens magnétiques comprennent au moins un anneau (11, 12) à aimantation radiale.

10. Dispositif selon l'une des revendications précédentes, **caractérisé en ce que** lesdits éléments annulaires des seconds moyens magnétiques (2) comprennent au moins un anneau à aimantation multipolaire (21).

11. Dispositif selon l'une des revendications précédentes, **caractérisé en ce que** lesdits moyens (5) de transfert de l'énergie électromagnétique sont pourvus d'un organe d'adaptation de leur impédance avec celle du plasma.

12. Dispositif selon l'une des revendications précédentes, **caractérisé en ce qu'**il comprend, en outre, des moyens (7) pour extraire les ions formés de ladite enceinte (E).
